(19) Europäisches Patentamt
European Patent Office
Office européen des brevets

(11) **EP 4 306 686 A1**

(12) **EUROPEAN PATENT APPLICATION**
published in accordance with Art. 153(4) EPC

(43) Date of publication:
**17.01.2024 Bulletin 2024/03**

(21) Application number: **22767231.8**

(22) Date of filing: **10.03.2022**

(51) International Patent Classification (IPC):
*C30B 25/14* (2006.01)   *H01L 21/365* (2006.01)
*H01L 21/368* (2006.01)   *C23C 16/455* (2006.01)

(52) Cooperative Patent Classification (CPC):
**C23C 16/455; C30B 25/14; H01L 21/02107**

(86) International application number:
**PCT/JP2022/010549**

(87) International publication number:
**WO 2022/191277 (15.09.2022 Gazette 2022/37)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **12.03.2021 JP 2021040704**

(71) Applicant: **SHIN-ETSU CHEMICAL CO., LTD.**
**Tokyo 1000005 (JP)**

(72) Inventors:
• **SAKATSUME Takahiro**
**Annaka-shi, Gunma 379-0195 (JP)**
• **HASHIGAMI Hiroshi**
**Annaka-shi, Gunma 379-0195 (JP)**

(74) Representative: **Mooser, Sebastian Thomas**
**Wuesthoff & Wuesthoff**
**Patentanwälte PartG mbB**
**Schweigerstraße 2**
**81541 München (DE)**

(54) **FILM FORMATION DEVICE, FILM FORMATION METHOD, GALLIUM OXIDE FILM, AND LAMINATE**

(57)   The present invention is a film-forming apparatus that heat-treats a raw material solution atomized into a mist to perform film-formation on a substrate, the film-forming apparatus including: a mist part that generates a mist by atomizing the raw material solution into a mist; a carrier gas supplier that supplies a carrier gas to carry the mist generated in the mist part; a film-forming part inside which a placement part on which the substrate is placed is provided, and in which the mist carried by the carrier gas is suppled onto the substrate; and an exhaust part that exhausts an exhaust gas from the film-forming part, the film-forming apparatus further including: above the placement part inside the film-forming part, a nozzle that supplies the mist onto the substrate; and a top plate that rectifies the mist supplied from the nozzle. This configuration provides a film-forming apparatus and a film-forming method to which the mist CVD method is applicable and which are capable of forming a film with excellent in-plane uniformity of film thickness.

[FIG. 1]

**Description**

TECHNICAL FIELD

The present invention relates to a film-forming apparatus that performs film-formation on a substrate using a mist-like raw material solution, a film-forming method, a gallium oxide film, and a laminate.

BACKGROUND ART

A high-vacuum film-formation apparatus that can achieve non-equilibrium state, such as pulsed laser deposition (PLD), molecular beam epitaxy (MBE), and sputtering, have been developed, enabling to fabricate an oxide semiconductor that was previously impossible to fabricate using a conventional method such as a melt method. Mist chemical vapor deposition (hereinafter referred to as a mist CVD method) using the atomized mist-like raw material solution to grow crystal on a substrate, has also been developed, enabling to fabricate a gallium oxide ($\alpha$-Ga$_2$O$_3$) having a corundum structure. As a semiconductor with a large band gap, $\alpha$-Ga$_3$O$_3$ is expected to be applied to next-generation switching device that can achieve high-voltage, low loss, and high heat resistance.

With reference to the mist CVD method, Patent Document 1 describes a tubular furnace type mist CVD apparatus. Patent document 2 describes a fine channel type mist CVD apparatus. Patent document 3 describes a linear source type mist CVD apparatus. Patent document 4 describes a mist CVD apparatus of a tubular furnace, which differs from the mist CVD apparatus described in patent document 1 in that a carrier gas is introduced into a mist generator. Patent document 5 describes a mist CVD apparatus in which a substrate is placed above a mist generator and a susceptor is a rotating stage mounted on a hot plate.

CITATION LIST

PATENT LITERATURE

Patent Document 1: JP H01-257337 A
Patent Document 2: JP 2005-307238 A
Patent Document 3: JP 2012-46772 A
Patent Document 4: JP 5397794 B1
Patent Document 5: JP 2014-63973 A

SUMMARY OF INVENTION

TECHNICAL PROBLEM

Unlike the other CVD methods, the mist CVD method can perform a film-formation at relatively low temperatures, and it is also possible to fabricate a crystal structure of a metastable phase such as the corundum structure of $\alpha$-Ga$_2$O$_3$.

However, the present inventors have found a problem that when a mist is supplied from above a substrate, thermal convection and mixing of a mist-containing gas and an ambient gas disturb a mist flow, which makes it difficult to maintain in-plane uniformity of film thickness of a film to be formed.

The present invention has been made in order to solve the above problem, and an object thereof is to provide a film-forming apparatus and a film-forming method to which the mist CVD method is applicable and which are capable of forming a film with excellent in-plane uniformity of film thickness.

SOLUTION TO PROBLEM

The present invention has been made in order to achieve the above object, and provides a film-forming apparatus that heat-treats a raw material solution atomized into a mist to perform film-formation on a substrate, the film-forming apparatus including:

a mist part that generates a mist by atomizing the raw material solution into a mist;
a carrier gas supplier that supplies a carrier gas to carry the mist generated in the mist part;
a film-forming part inside which a placement part on which the substrate is placed is provided, and in which the mist carried by the carrier gas is suppled onto the substrate; and

an exhaust part that exhausts an exhaust gas from the film-forming part,
the film-forming apparatus further including:

above the placement part inside the film-forming part,
a nozzle that supplies the mist onto the substrate; and
a top plate that rectifies the mist supplied from the nozzle.

With such a film-forming apparatus, it is possible to form a film with good in-plane uniformity of film thickness. The synergistic effect of a rectification effect by the top plate and a convection current generated by the supply of the mist from the nozzle and the exhaust of the exhaust gas from the exhaust part generates a uniform gas flow along the substrate (parallel to the surface of the substrate) above the substrate, enabling the formation of a uniform film on the substrate.

The nozzle and the top plate can be provided vertically above the placement part.

This enables a film with good in-plane uniformity of film thickness to be formed.

The top plate can be provided in contact with a side surface of the nozzle.

This enables a film with good in-plane uniformity of film thickness to be formed.

The top plate can be provided in the same plane as an opening surface of the nozzle.

This enables a film with good in-plane uniformity of film thickness to be formed.

The top plate can be provided such that a bottom surface of the top plate is parallel to a surface on which the substrate is placed of the placement part.

This enables a film with good in-plane uniformity of film thickness to be formed.

The top plate can be provided such that a difference in height position between a bottom surface of the top plate and a surface on which the substrate is placed of the placement part is 0.15 cm or more and 6.05 cm or less.

This enables a film with even better in-plane uniformity of film thickness to be formed.

The nozzle can be provided such that a difference in height position between an opening surface of the nozzle and the substrate placed on the placement part is 0.1 cm or more and 6.0 cm or less.

This enables a film with even better in-plane uniformity of film thickness to be formed.

When an area of a bottom surface of the top plate is B [cm$^2$], B $\geq$ 40.

This enables a film with even better in-plane uniformity of film thickness to be formed.

When an area of the substrate is A [cm$^2$] and an area of a bottom surface of the top plate is B [cm$^2$], B/A $\geq$ 0.5.

This enables a film with even better in-plane uniformity of film thickness to be formed.

A moving mechanism that moves the substrate below the nozzle can be further included.

This enables a films with good in-plane uniformity of film thickness and with a large area to be formed.

The raw material solution can contain gallium.

This enables a gallium oxide film with good in-plane uniformity of film thickness to be formed.

The raw material solution can contain halogen.

This enables a film with good in-plane uniformity of film thickness to be formed.

The present invention provides a film-forming method that heat-treats a raw material solution atomized into a mist to perform film-formation on a substrate, the method including:

a mist generation step of generating a mist by atomizing the raw material solution into a mist;
a mist carrying step of carrying the mist to a film-forming part by a carrier gas; and
a film-forming step of supplying the mist onto the substrate placed on a placement part inside the film-forming part and heat-treating the mist to perform film-formation while exhausting an exhaust gas, in which
in the film-forming step,
when supplying the mist onto the substrate, by supplying the mist from a nozzle provided above the placement part to between a top plate provided above the placement part and the substrate, the mist rectified is supplied onto the substrate.

This enables a film with good in-plane uniformity of film thickness to be formed. The synergistic effect of the rectification effect by the top plate and the convection current generated by the supply of the mist from the nozzle and the exhaust of the exhaust gas generates a uniform gas flow along the substrate (parallel to the surface of the substrate) above the substrate, enabling the formation of a uniform film on the substrate.

The nozzle and the top plate can be provided vertically above the placement part.

This enables a film with good in-plane uniformity of film thickness to be formed.

The top plate can be provided in contact with a side surface of the nozzle.

This enables a film with good in-plane uniformity of film thickness to be formed.

The top plate can be provided in the same plane as an opening surface of the nozzle.

This enables a film with good in-plane uniformity of film thickness to be formed.

The top plate can be provided such that a bottom surface of the top plate is parallel to a surface on which the substrate is placed of the placement part.

This enables a film with good in-plane uniformity of film thickness to be formed.

The top plate can be provided such that a difference in height position between a bottom surface of the top plate and a surface on which the substrate is placed of the placement part is 0.15 cm or more and 6.05 cm or less.

This enables a film with even better in-plane uniformity of film thickness to be formed.

The nozzle can be provided such that a difference in height position between an opening surface of the nozzle and the substrate placed on the placement part is 0.1 cm or more and 6.0 cm or less.

This enables a film with even better in-plane uniformity of film thickness to be formed.

When an area of a bottom surface of the top plate is B [cm$^2$], B ≥ 40.

This enables a film with even better in-plane uniformity of film thickness to be formed.

When an area of the substrate is A [cm$^2$] and an area of a bottom surface of the top plate is B [cm$^2$], B/A ≥ 0.5.

This enables a film with even better in-plane uniformity of film thickness to be formed.

In the film-forming step, the substrate can be moved below the nozzle.

This enables a film with good in-plane uniformity of film thickness and with a large area to be formed.

The raw material solution can contain gallium.

This enables a gallium oxide film with good in-plane uniformity of film thickness to be formed.

The raw material solution can contain halogen.

This enables a film with good in-plane uniformity of film thickness to be formed.

When a flow rate of the carrier gas supplied from the nozzle is Q [L/min] and a flow rate of the exhaust gas is E [L/min], E/Q can be 5 or less.

This enables a film with even better in-plane uniformity of film thickness to be formed.

In the substrate, a surface on which a film is formed can have an area of 50 cm$^2$ or more, or have a diameter of 4 inches (100 mm) or more.

This enables a film with good in-plane uniformity of film thickness and with a large area to be formed.

The present invention provides a gallium oxide film with a corundum structure, in which

the gallium oxide film has an area of 50 cm$^2$ or more, or has a diameter of 4 inches (100 mm) or more, and
an in-plane distribution of a film thickness of the gallium oxide film is ±3.1% or more and ±11.7% or less.

Such a gallium oxide film is a film with good in-plane uniformity of film thickness and with a large area.

The present invention provides a laminate of a substrate and a gallium oxide film with a corundum structure, in which

the gallium oxide film of the laminate has an area of 50 cm$^2$ or more, or has a diameter of 4 inches (100 mm) or more, and
an in-plane distribution of a film thickness of the gallium oxide film is ±3.1% or more and ±11.7% or less.

Such a laminate is a laminate having on a substrate a gallium oxide film with good in-plane uniformity of film thickness and with a large area.

ADVANTAGEOUS EFFECTS OF INVENTION

As described above, the film-forming apparatus and the film-forming method of the present invention can form a film with good in-plane uniformity of film thickness on a substrate using a mist-like raw material solution.

Further, the gallium oxide film and the laminate of the present invention can obtain a gallium oxide film with good in-plane uniformity of film thickness and with a large area.

BRIEF DESCRIPTION OF DRAWINGS

FIG. 1 is a schematic configuration view showing an example of a film-forming apparatus in the present invention.
FIG. 2 is a view describing an example of a mist part in the present invention.
FIG. 3 is a view describing an example of a film-forming part in the present invention.
FIG. 4 is a view describing an example of a nozzle in the present invention.
FIG. 5 is a view describing an example of a case with a plurality of nozzles.

FIG. 6 is a view describing an example of the nozzle provided with a plurality of opening surfaces.

FIG. 7 is a view describing an example of the film-forming part in the present invention.

FIG. 8 is a view describing an example of the film-forming part in the present invention.

FIG. 9 is a view describing an example of the film-forming part in the present invention.

FIG. 10 is a view describing an example of the film-forming part in the present invention.

FIG. 11 is a view describing an example of the film-forming part in the present invention.

FIG. 12 is a view describing an example of a moving mechanism for a substrate in the present invention.

FIG. 13 is a view describing an example of the moving mechanism that reciprocates under the nozzle.

FIG. 14 is a view describing an example of the moving mechanism that rotates and moves under the nozzle in one direction.

FIG. 15 is a view showing a top plate used in Example 10.

FIG. 16 is a view describing an example of an exhaust part in the present invention.

FIG. 17 is a view showing the top plate (rectangular shape) used in an example.

FIG. 18 is a view describing an example of a film-forming apparatus used in Example 13.

FIG. 19 is a schematic cross-sectional view showing an example of a gallium oxide film and a laminate in the present invention.

DESCRIPTION OF EMBODIMENTS

The present invention will be described in detail below, but the present invention is not limited to these.

As described above, there have been demanded a film-forming apparatus and a film-forming method capable of forming a film with good in-plane uniformity of film thickness in the mist CVD method.

The present inventors have intensively studied the above problem and consequently found that it is possible to form a film with excellent in-plane uniformity of film thickness by a film-forming apparatus that heat-treats a raw material solution atomized into a mist to perform film-formation on a substrate, the film-forming apparatus including: a mist part that generates a mist by atomizing the raw material solution into a mist; a carrier gas supplier that supplies a carrier gas to carry the mist generated in the mist part; a film-forming part inside which a placement part on which the substrate is placed is provided, and in which the mist carried by the carrier gas is suppled onto the substrate; and an exhaust part that exhausts an exhaust gas from the film-forming part, the film-forming apparatus further including: above the placement part inside the film-forming part, a nozzle that supplies the mist onto the substrate; and a top plate that rectifies the mist supplied from the nozzle. This finding has led to the completion of the present invention.

The present inventors have found that it is possible to form a film with excellent in-plane uniformity of film thickness by a film-forming method that heat-treats a raw material solution atomized into a mist to perform film-formation on a substrate, the method including: a mist generation step of generating a mist by atomizing the raw material solution into a mist; a mist carrying step of carrying the mist to a film-forming part by a carrier gas; and a film-forming step of supplying the mist onto the substrate placed on a placement part inside the film-forming part and heat-treating the mist to perform film-formation while exhausting an exhaust gas, in which in the film-forming step, when supplying the mist onto the substrate, by supplying the mist from a nozzle provided above the placement part to between a top plate provided above the placement part and the substrate, the mist rectified is supplied onto the substrate. This finding has led to the completion of the present invention.

The present inventors have found that a gallium oxide film with a corundum structure, in which the gallium oxide film has an area of 50 $cm^2$ or more, or has a diameter of 4 inches (100 mm) or more, and an in-plane distribution of a film thickness of the gallium oxide film is $\pm 3.1\%$ or more and $\pm 11.7\%$ or less, and further a laminate of a substrate and a gallium oxide film with a corundum structure, in which the gallium oxide film of the laminate has an area of 50 $cm^2$ or more, or has a diameter of 4 inches (100 mm) or more, and an in-plane distribution of a film thickness of the gallium oxide film is $\pm 3.1\%$ or more and $\pm 11.7\%$ or less, can be a gallium oxide film with good in-plane uniformity of film thickness and with a large area and a laminate having the gallium oxide film on the substrate. This finding has led to the completion of the present invention.

Hereinafter, description will be given with reference to the drawings.

(Gallium Oxide Film)

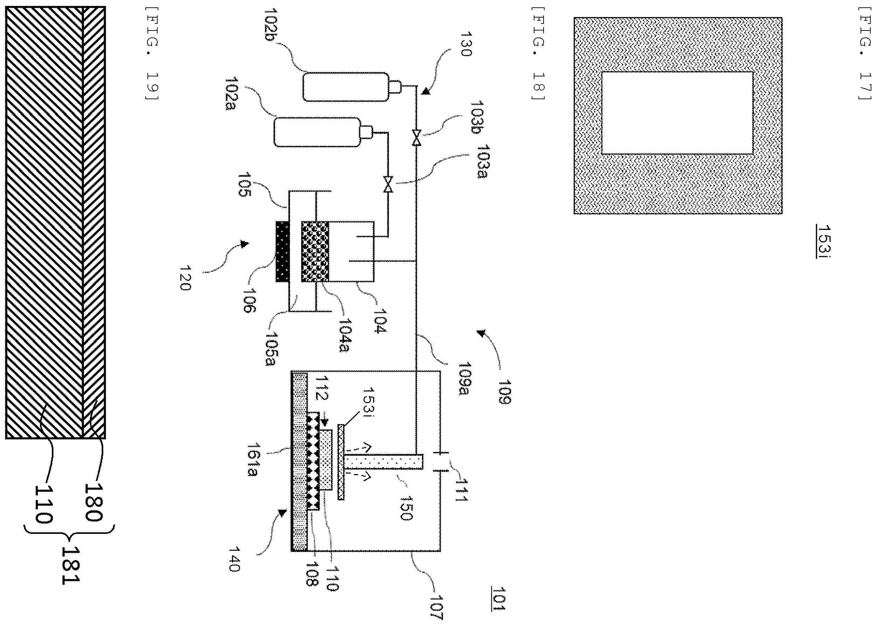

FIG. 19 shows a schematic cross-sectional view of an example of a gallium oxide film of the present invention (and a laminate of the present invention).

A gallium oxide film 180 with a corundum structure of the present invention has a feature in that it has an area of 50 $cm^2$ or more, or a diameter of 4 inches (100 mm) or more, and an in-plane distribution of film thickness is $\pm 3.1\%$ or more and $\pm 11.7\%$ or less. The larger the area or diameter of the film, the larger the area of the gallium oxide film can be obtained. Therefore, the upper limit thereof is not particularly limited, but as an example of the upper limit, the area

can be 750 cm$^2$, or the diameter can be 12 inches (300 mm). Generally, oxide semiconductor films are composed of metal and oxygen, and in the gallium oxide film 180 of the present invention, the main component of the metal is gallium. The main component herein means that 50 to 100% of a metal component is gallium. As the metal component other than gallium, for example, one, or two or more metals selected from iron, indium, aluminum, vanadium, titanium, chromium, rhodium, iridium, nickel, and cobalt, may be contained.

The in-plane distribution of film thickness is ±3.1% or more and ±11.7% or less, but less than ±8.2% is more preferable. Herein, the in-plane distribution of film thickness in the present invention is the one in which for example nine or more points in the plane are measured and calculated as

$$\texttt{film thickness distribution [±\%] = (maximum film}$$

$$\texttt{thickness - minimum film thickness)/(average film}$$

$$\texttt{thickness)/2 × 100.}$$

The film thickness can be measured with a step film thickness gauge (step gauge), an optical interference type film thickness meter or the like, but a measurement method is not particularly limited as long as the film thickness at each location can be measured.

As a reason for deterioration (increase) of the in-plane distribution of film thickness in conventional film-forming apparatuses and film-forming methods, it is conceivable that a mist supply amount becomes uneven and a temperature distribution is generated in the substrate due to a mist supply method, a mist supply amount, a structure around a substrate and the like. As a result of intensive investigation and repeated trial and error by the present inventors, the present inventors have thought that the appropriate structure around the substrate, as in the film-forming apparatus to be described later, makes the supply amount uniform and enables good in-plane uniformity of film thickness distribution, and the present inventors have succeeded for the first time in obtaining a film with good uniformity of in-plane distribution of film thickness and with a large area as described above.

The gallium oxide film 180 of the present invention can contain a dopant depending on its application. The dopant is not particularly limited. Examples of the dopant include an n-type dopant such as tin, germanium, silicon, titanium, zirconium, vanadium and niobium, or a p-type dopant such as copper, silver, tin, iridium and rhodium. The concentration of the dopant may be, for example, about $1.0 \times 10^{16}$ to $1.0 \times 10^{22}/cm^3$, and it may be a low concentration of about $1.0 \times 10^{17}/cm^3$ or less, or a high concentration of about $1.0 \times 10^{20}/cm^3$ or more.

The film thickness of the oxide semiconductor film 180 of the present invention is not particularly limited. For example, it may be 0.05 to 100 um, preferably 0.1 to 50 $\mu$m, and more preferably 0.5 to 20 $\mu$m.

(Laminate)

A laminate 181 of the present invention has a feature in that it includes, on a substrate 110, the gallium oxide film 180 with a corundum structure and with an area of 50 cm$^2$ or more, or a diameter of 4 inches (100 mm) or more.

Another layer may be interposed between the substrate 110 and the gallium oxide film 180. Another layer is a layer that differs in composition from the substrate 110 and the gallium oxide film 180 that is the outermost surface layer, and may be any of, for example, a crystalline oxide film, an insulating film, a metal film, and the like.

The gallium oxide film 180 and the laminate 181 of the present invention can be used for semiconductor apparatuses by appropriately designing structures. For example, they can constitute a semiconductor layer of each of a Schottky barrier diode (SBD), metal semiconductor field effect transistor (MESFET), high electron mobility transistor (HEMT), metal oxide semiconductor field effect transistor (MOSFET), static induction transistor (SIT), junction field effect transistor (JFET), insulated gate bipolar transistor (IGBT), light-emitting diode (LED), and the like.

The gallium oxide film 180 and the laminate 181 of the present invention can be formed with the film-forming apparatus of the present invention to be described later. The film-forming apparatus and the film-forming method of the present invention will be described.

Herein, a mist in the present invention refers to a generic term for liquid particles dispersed in a gas, and also includes what is called a fog, droplets, or the like.

(Film-Forming Apparatus)

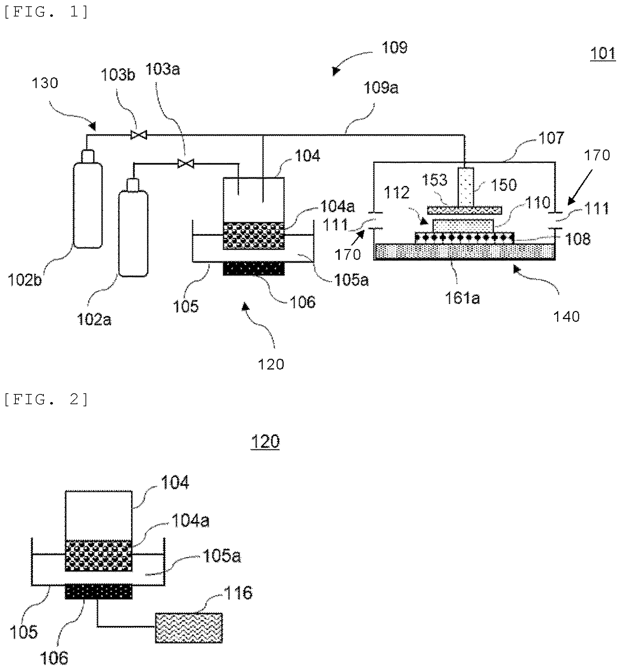

FIG. 1 shows an example of a film-forming apparatus 101 of the present invention. The film-forming apparatus 101 includes a mist part 120 that generates a mist by atomizing a raw material solution into a mist, a carrier gas supplier 130 that supplies a carrier gas to carry the mist, a film-forming part 140 that heat-treats the mist to perform film-formation on a substrate, a carrying part 109 that connects the mist part 120 and the film-forming part 140 and carries the mist by the carrier gas, and an exhaust part 170 that exhausts an exhaust gas from the film-forming part 140. Further, the film-forming apparatus 101 may include a control unit (not shown) that controls the whole or part of the film-forming apparatus 101, and the operation thereof may be controlled.

(Mist Part)

The mist part 120 generates the mist by atomizing the raw material solution into the mist. Means for atomizing the raw material solution into the mist is not particularly limited as long as it can atomize the raw material solution into the mist, and any known means may be used. However, it is preferable that ultrasonic vibration is used as such means. This is because it can atomize the raw material solution into the mist more stably.

An example of such a mist part 120 is shown in FIG. 2. For example, it may include a mist generator 104 in which a raw material solution 104a is contained, a container 105 in which a medium capable of transmitting ultrasonic vibrations, e.g., water 105a, is contained, and an ultrasonic transducer 106 attached to the bottom surface of the container 105. In detail, the mist generator 104, which consists of a container in which the raw material solution 104a is contained, is housed in the container 105 in which the water 105a is contained, using a support (not shown). The ultrasonic transducer 106 is provided on the bottom portion of the container 105, and the ultrasonic transducer 106 is connected to an oscillator 116. When the oscillator 116 is activated, the ultrasonic transducer 106 vibrates, and ultrasonic waves propagate into the mist generator 104 through the water 105a, thereby atomizing the raw material solution 104a into the mist.

(Carrier Gas Supplier)

The carrier gas supplier 130 may include a carrier gas source 102a that supplies a carrier gas (main carrier gas) and a flow regulating valve 103a for regulating the flow rate of the main carrier gas delivered from the carrier gas source 102a. It can also include a carrier gas source for dilution 102b that supplies a carrier gas for dilution (carrier gas for dilution) as needed and a flow regulating valve 103b for regulating the flow rate of the carrier gas for dilution delivered from the carrier gas source for dilution 102b.

The type of the carrier gas is not particularly limited and can be appropriately selected depending on a film to be formed. Examples of the carrier gas include oxygen, ozone, an inert gas such as nitrogen or argon, or a reducing gas such as a hydrogen gas or forming gas. The type of the carrier gas may be one type, or two or more types. For example, a dilution gas in which the same gas as a first carrier gas is diluted (e.g., diluted 10 times) with a gas other than the first carrier gas, may further be used as a second carrier gas, or air can be used.

Further, a carrier gas supply location is not limited to one location, but may be two or more locations.

The flow rate of the carrier gas is not particularly limited. For example, when a film is formed on the substrate with a diameter of 4 inches (10 cm), the flow rate is preferably 1 to 80 L/min, and is more preferably 4 to 40 L/min.

Note that a flow rate Q of the carrier gas is a value measured at 20°C, and when the flow rate is measured at other temperatures, or different types of flow rates (mass flow rate, etc.) are measured, it can be converted to a volumetric flow rate at 20°C using an equation of state of gas.

(Film-Forming Part, Exhaust Part)

The film-forming part 140 heats the mist to generate a thermal reaction, and performs film-formation on part or all of the surface of the substrate 110. The film-forming part 140 may be partially or entirely enclosed. For example, as shown in FIG. 1, the entire film-forming part 140 may be enclosed to be a film-forming chamber 107. The film-forming chamber 107 is not limited to a completely enclosing shape, but may be a shape with a gap and enclosing only part of the film-forming part. The film-forming part 140 includes a placement part 112 on which the substrate is placed. The substrate 110 is provided on the film-forming part 140, and the film-forming part 140 can include a hot plate 108 for heating the substrate 110. The hot plate 108 may be provided inside the film-forming chamber 107 as shown in FIG. 1, or may be provided outside the film-forming chamber 107.

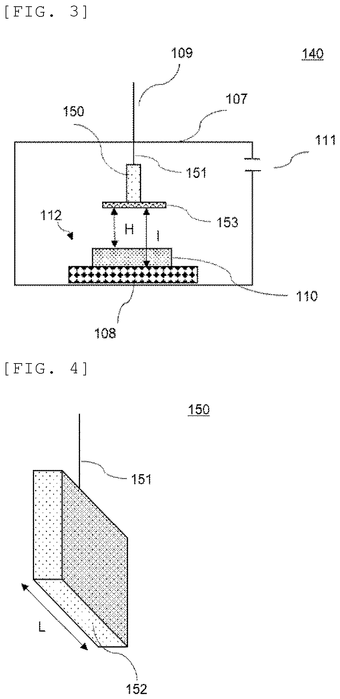

Further, the film-forming part 140 includes a nozzle 150 for supplying the mist to the substrate 110 above the placement part 112, as shown in FIG. 3.

An example of the nozzle 150 is shown in FIG. 4. The nozzle 150 includes a connection portion 151 that connects the carrying part 109 to the nozzle 150, and a nozzle opening surface (also simply referred to as opening surface) 152 for ejecting the mist.

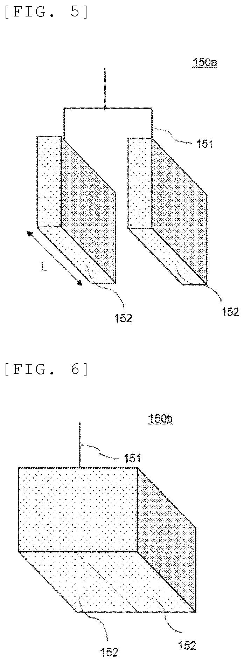

The number of nozzles and the number of opening surfaces are not particularly limited as long as the numbers thereof are each one or more. A plurality of nozzles (nozzle 150a) may be provided as shown in FIG. 5, or a plurality of opening surfaces (nozzle 150b) may be provided as shown in FIG. 6.

The angle formed by a plane including the nozzle opening surface 152 and a plane including the substrate 110 is not particularly limited. A nozzle with a nozzle opening surface that is inclined to facilitate a mist flow in a particular direction may be provided, but it is preferable that the nozzle opening surface is parallel to the surface on which the substrate 110 is placed of the placement part 112, as shown in FIG. 3. This is because a film with better in-plane uniformity of film thickness can be formed with a simpler structure.

When the area of the nozzle opening surface 152 is S [$cm^2$], the flow rate of the carrier gas is Q [L/min], and the difference in height position between the nozzle opening surface 152 and the substrate 110 (e.g., the longest distance between a point in the nozzle opening surface 152 and the surface of the substrate 110) is H [cm], SH/Q is preferably 0.015 or more, and is more preferably 0.1 or more and 20 or less. when SH/Q $\geq$ 0.015, the film has better in-plane uniformity of film thickness.

In this case, the speed of the gas in a direction orthogonal to the substrate at the nozzle opening surface 152 is preferably 0.01 or more and 8.0 m/s or less, and more preferably 0.1 or more and 2.0 m/s or less.

In this case, the area S of the nozzle opening surface 152 is preferably 0.1 or more and 400 or less. The difference in height position H between the nozzle opening surface 152 and the substrate 110 is preferably 0.1 or more and 6.0 or less, and more preferably 0.2 or more and 3.0 or less. This is because a film to be formed has better in-plane uniformity of film thickness.

When the area of the nozzle opening surface 152 is S [$cm^2$] and the area of the substrate is A [$cm^2$], S/A $\leq$ 0.3 is preferable, and 0.004 $\leq$ S/A $\leq$ 0.15 is more preferable. When S/A $\leq$ 0.3, a film has better in-plane uniformity of film thickness. In this case, the area A of the substrate is preferably 10 $cm^2$ or more, and more preferably 50 $cm^2$ or more, and the upper limit thereof is not particularly limited. The larger the area of the substrate becomes, the larger the area of the film can be obtained with single film-formation, and thus it is suitable for high-volume production.

The shape of the nozzle opening surface 152 is not particularly limited. It may be polygonal, circular, oval, or the like, but it is preferably quadrilateral, and more preferably rectangular. When the shape of the nozzle opening surface 152 is rectangular, and the length of the long axis of the nozzle opening surface 152 is L [cm] and the maximum length of the substrate in the nozzle long axis direction is R [cm], it is preferable that L/R $\geq$ 1. When L/R $\geq$ 1, a film with good in-plane uniformity of film thickness can be formed on a substrate with a large area. The upper limit of L/R is not particularly limited, but is preferably 3 or less because the larger L/R is, the more mists are not supplied to the substrate.

As long as a top plate 153 is provided above the placement part 112 as shown in FIG. 3, the top plate 153 is not particularly limited in a shape, size, installation position, installation height, installation method, material, and the number thereof. For example, when the film-forming chamber 107 is provided, the top plate 153 may be provided between the ceiling of the film-forming chamber 107 and the substrate 110 in the placement part 112. By arranging the top plate 153, the mist flow is less likely to be disturbed by the flow of ambient gas due to thermal convection during film-formation processing by heat treatment, and the mist supplied from the nozzle 150 is rectified and supplied onto the substrate 110, and thus a film with excellent in-plane uniformity of film thickness can be formed.

As described above, the positions of the nozzle 150 and the top plate 153 are not particularly limited as long as they are positioned above the placement part 112, but as shown in FIG. 3, for example, they can each be positioned vertically above the top surface of the hot plate 108 on which the substrate 110 is placed. Such an arrangement is simple and allows a film with sufficiently excellent film thickness uniformity to be formed on the substrate.

The top plate 153 may include a temperature adjustment mechanism (not shown) that can adjust the temperature of the surface (bottom surface) of the substrate 110 facing the placement part 112. If the temperature of this surface (bottom surface) is too high, mist evaporation is accelerated, resulting in an increase in film thickness at locations away from the nozzle opening surface 152 on the substrate 110, and if the temperature is too low, mist evaporation slows and film thickness decreases at locations closer to the nozzle opening surface 152. It is preferable to control the temperature between about 40 to 120°C.

The top plate shape may be polygonal, semicircular, circular, or oval, but it is preferably quadrilateral. This is because the quadrilateral shape has high symmetry and a film to be formed has good in-plane uniformity of film thickness.

The top plate may be in contact with the side surface of the nozzle, or a gap may be provided. For example, a hole may be formed in the top plate (i.e., donut-shaped) and the nozzle may be inserted into the hole. In this case, the distance between the top plate and the side surface of the nozzle is preferably 2 cm or less, more preferably 1 cm or less, and even more preferably 0 cm. This is because the film has good in-plane uniformity of film thickness.

When the nozzle and the top plate are integrated, the distance between the top plate and the nozzle opening surface is 0 cm, and when they are separate, the distance is a value in which the thickness of the wall surface of the nozzle is subtracted from the shortest distance between the top plate and the nozzle opening surface. For example, when the distance between the top plate and the nozzle opening surface is 2.5 cm, the wall surface of the nozzle is included in the shortest distance, and the thickness of the wall surface of the nozzle is 0.5 cm, the shortest distance between the top plate and the nozzle opening surface is 2.0 cm.

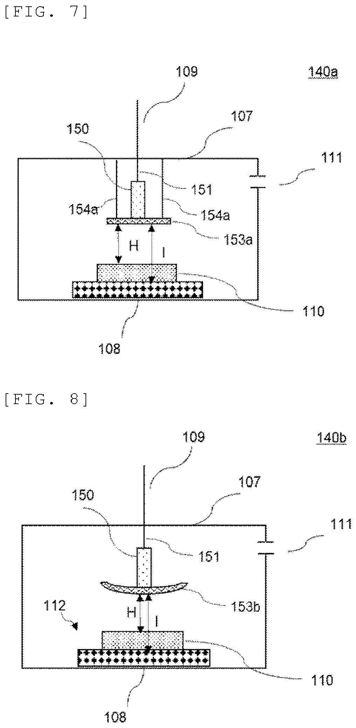

The top plate may be suspended from the film-forming chamber by a fixture 154a or the like, as in a top plate 153a in FIG. 7 (film-forming part 140a), but it is preferable that the top plate is fixed to the side surface of the nozzle as shown in FIG. 3. This is because a film to be formed has good in-plane uniformity of film thickness.

Part of or entire top plate may be curved or folded such that the mist can easily flow out in a particular direction, as in a top plate 153b in FIG. 8 (film-forming part 140b), but it is preferable to be provided parallel to the placement part 112, as shown in FIG. 3. More specifically, it is preferable that the top plate 153 is provided such that the surface on which the substrate 110 is placed of the placement part 112 is parallel to the bottom surface of the top plate 153. This is because a film to be formed has good in-plane uniformity of film thickness.

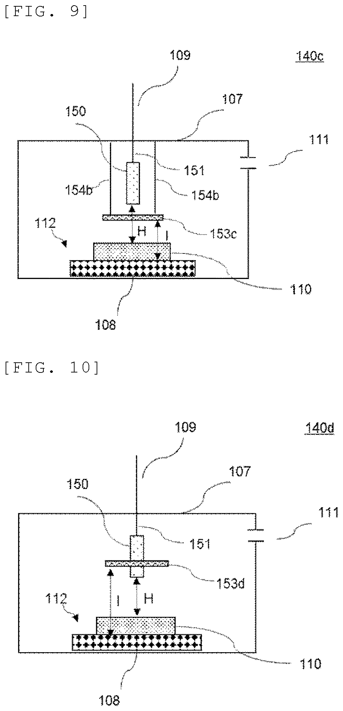

The top plate may be provided in the same plane as the opening surface of the nozzle, it may be closer to the substrate 110 than the opening surface of the nozzle 150, as in a top plate 153c suspended by a fixture 154b in FIG. 9 (film-forming part 140c), or it may be farther away from the substrate 110 than the opening surface of the nozzle 150, as in a top plate 153d in FIG. 10 (film-forming part 140d). However, it is more preferable to be provided in the same plane as the opening surface of the nozzle 150. This is because a film to be formed has better in-plane uniformity of film thickness.

The film-forming part 140 may include a position adjusting mechanism (not shown) that can appropriately adjust the difference in height position H [cm] between the nozzle opening surface 152 and the substrate 110 and the difference in height position I [cm] between the top plate 153 and the surface on which the substrate 110 is placed of the placement part 112.

The thickness of the top plate is not particularly limited, but 2 mm or more is preferable. This is because deformation due to heating during film-formation is suppressed.

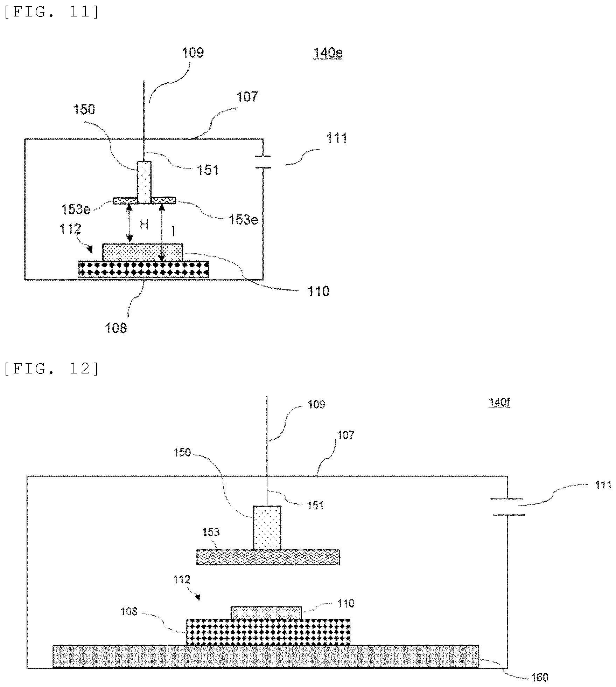

The number of top plates is not particularly limited. As shown in FIG. 3, the top plate may be one per nozzle, or as shown in FIG. 11 (film-forming part 140e), a plurality of top plates (herein two top plates 153e) per nozzle may be provided.

The material of the top plate is not particularly limited. It may be polysulfone, polyethersulfone, polyphenylene sulfide, polyetheretherketone, polyimide, polyetherimide, fluororesin, metals such as iron, aluminum, stainless steel, and gold, quartz, glass or the like.

The difference in height position between the bottom surface of the top plate 153 and the surface on which the substrate is placed of the placement part 112 (e.g., the shortest difference in height position) I [cm] is not particularly limited, but is preferably 0.15 cm or more and 6.05 cm or less, more preferably 0.5 cm or more and 3.0 cm or less, and even more preferably 1.0 cm or more and 2.0 cm or less. This is because a film to be formed has better in-plane uniformity of film thickness.

When the area of the bottom surface of the top plate (the total area when a plurality of top plates are provided) is B [cm$^2$] and the area of the substrate is A [cm$^2$], it is preferable that B/A ≥ 0.5, and 1 or more is more preferable. When B/A ≥ 0.5, the film has good in-plane uniformity of film thickness. Also, B is preferably 40 or more. Within these numerical values, the film with more excellent in-plane uniformity of film thickness is formed. The upper limits of B/A and B are not particularly limited. This is because the rectification effect by the top plate is produced if the value is larger than the above value. However, it is preferable that B/A is 100 or less. As an example of the upper limit of B, it can be 3000. This is because it prevents the apparatus from becoming larger than necessary.

The film-forming part 140 can include a moving mechanism that moves the substrate 110 below the nozzle 150. An example of a film-forming part 140f including the moving mechanism 160 is shown in FIG. 12. A direction in which the substrate is moved is not particularly limited.

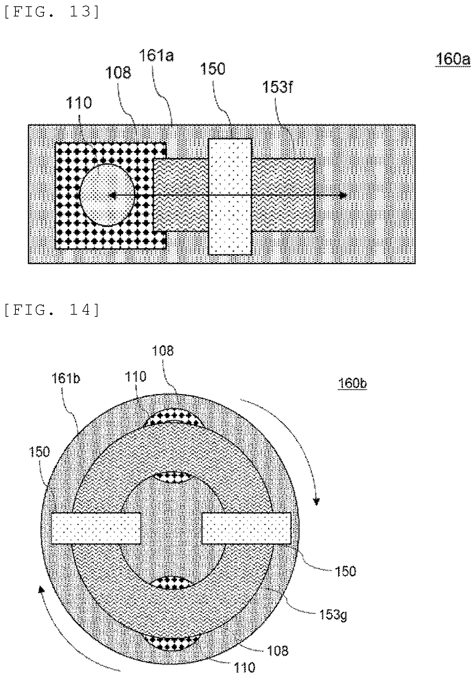

The film-forming part 140 including the moving mechanism 160 viewed from above the placement part is shown in FIGS. 13 and 14. There is a method as shown in FIG. 13 (moving mechanism 160a) in which a moving stage 161a on which the substrate 110 and the hot plate 108 are placed is provided, and the substrate 110 and the hot plate 108 move back and forth under the nozzle 150 and two rectangular top plates 153f. Further, there is a method as shown in FIG. 14 (moving mechanism 160b) in which the substrate 110 and the hot plate 108 are rotated and moved under the nozzle 150 and two top plates 153g shaped like a circle divided in half, by a moving stage 161b on which the substrate 110 and the hot plate 108 are placed. In this case, a mechanism that allows the substrate to rotate on its own axis may be provided, and the substrate may rotates on its own axis.

A plurality of substrates 110 and nozzles 150 may be provided in the film-forming part 140 as shown in FIG. 14, or a plurality of substrates may be provided in the film-forming part 140 in FIG. 13. Such a structure is even more suitable for high-volume production because it can form films on many substrates at once while maintaining in-plane uniformity of film thickness.

When the moving mechanism 160 of the substrate is provided, a speed at which the substrate is moved and a movement range are not particularly limited, but the number of times a single substrate passes under the nozzle per minute is preferably 0.1 times or more, more preferably 0.5 times or more, and even more preferably 1 time or more. By setting the number of times to 0.1 or more, it is possible to prevent the rectification effect by the top plate from becoming difficult to produce because of an upward current associated with local mist evaporation having a significant effect on the supply gas, and thus it is possible to more reliably prevent the deterioration of film thickness uniformity. The upper limit of the number of times is not particularly limited, but 120 times or less is preferable and 60 times or less is more preferable because an increase in the number of times causes unstable fixation of the substrate due to inertial force.

More specifically, in the case of the moving mechanism as shown in FIG. 13, when the movement speed of the substrate is v [mm/min] relative to a width D [mm] between which the substrate is moved, v/D [/min] is preferably 0.1 or more, more preferably 0.5 or more and 120 or less, and even more preferably 1 to 60. D is not particularly limited. For example, D is preferably the diameter [mm] of the substrate or more (100 or more if the diameter of the substrate is 4 inches), and the upper limit is not particularly limited. The larger D becomes, the more films can be formed on a large number of substrates per nozzle. However, since the film-formation speed per substrate is reduced, it is preferable to set D to 1000 mm or less and to limit the number of substrates on which films are to be formed per nozzle for better productivity. V is not particularly limited. V is preferably 10 mm/min or more and 30000 mm/min or less, more preferably 30 mm/min or more and 12000 mm/min or less, and even more preferably 60 mm/min or more and 6000 mm/min or less. In the case of a rotary type moving mechanism as shown in FIG. 14, 0.1 rpm or more is preferable, 0.5 to 120 rpm is more preferable, and 1 to 60 rpm is even more preferable.

The film-forming part 140 (film-forming chamber 107) includes an exhaust part 170 that rectifies a subsequent gas after the mist supplied with the carrier gas onto the substrate 110 is used for film-formation (referred to as exhaust gas, which includes the mist not used for film-formation, gas generated during film-formation, the carrier gas, and the like) such that the gas flows to the outside of the substrate 110. The exhaust gas is exhausted from the film-forming part 140 through the exhaust part 170.

The synergistic effect of the rectification effect by the top plate 153 and the convection current generated by the supply of the mist from the nozzle 150 and the exhaust gas exhausted from the exhaust part 170 generates a uniform gas flow parallel to the surface of the substrate 110 above the substrate 110, enabling the formation of a uniform film on the substrate 110.

The exhaust part 170 is not particularly limited in its shape and configuration as long as it can exhaust the exhaust gas from the film-forming part 140. For example, as shown in FIG. 1, an exhaust port 111 may be provided on the lateral position of the substrate 110 in the film-forming chamber 107, and forced exhaust may be performed. A configuration in which the carrier gas or the like supplied to between the top plate 153 and the substrate 110 from the nozzle 150 flows to the outside of the substrate 110 is particularly preferable.

The outside of the substrate 110 herein means an area that does not include the substrate 110 in the xy-plane at all z, with the normal direction of a plane that includes a substrate surface as the z-axis.

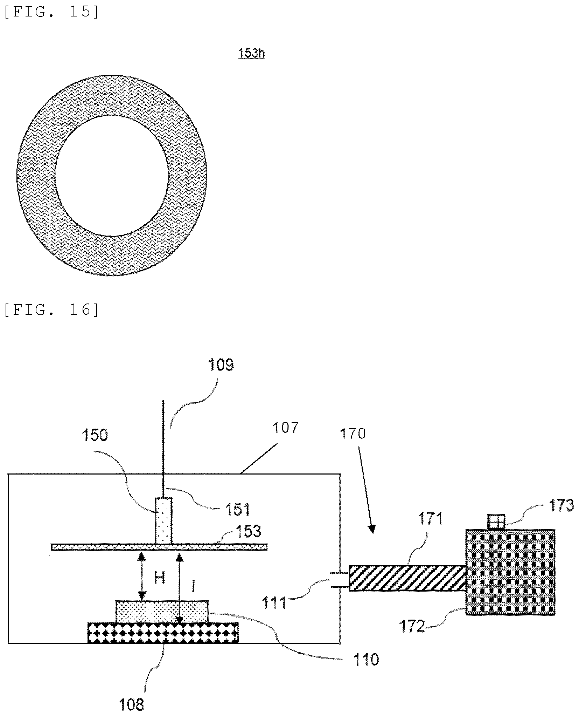

The exhaust part 170 can be the exhaust port 111 itself provided on the film-forming chamber 107 as described above, or it can be the exhaust port 111 to which means for forced exhaust is further added. An example of such an exhaust part 170 is shown in FIG. 16. For example, an exhaust unit 172 provided outside the film-forming chamber 107 forces the gas inside the film-forming chamber 107 to be exhausted from the exhaust port 111 provided on the side surface of the film-forming chamber 107 through an exhaust duct 171. The exhaust unit 172 includes an exhaust flow regulating valve 173 for regulating an exhaust gas flow rate, and can regulate the exhaust gas flow rate. The exhaust gas flow rate is not particularly limited, but when the flow rate of the carrier gas supplied from the nozzle 150 is Q [L/min] and the amount of exhaust exhausted from the exhaust part 170 is E [L/min], it is preferable that E/Q is 5 or less, and it is more preferable that E/Q is 0.1 or more and 1 or less. This is because the film has good in-plane uniformity of film thickness. In this case, E exhausted from the exhaust part 170 can be measured at 20°C with a flow meter at the exhaust port 111, or calculated by the product of a linear velocity measured with an anemometer and the area of the opening surface of the exhaust port 111. When an air velocity is measured at other temperatures, or when the flow rate is measured by other methods or temperatures, it can be converted to a volumetric flow rate at 20°C using an equation of state of gas.

The shape of the exhaust port 111 is not particularly limited to circular, rectangular, or the like.

The exhaust part 170 may be provided at one location as shown in FIG. 3, or may be provided at two or more locations as shown in FIG. 1. However, when the exhaust parts 170 are provided at two or more locations, it is preferable that they are provided symmetrically with respect to the center of the nozzle opening surface. This is because it enables formation of a film with good in-plane uniformity of film thickness.

The exhaust part 170 may include a temperature control mechanism (not shown) that controls the temperature of part of or entire exhaust part to suppress the precipitation of solids in the exhaust part. Such a temperature control mechanism suppresses the precipitation of solids in the exhaust part 170, making it easier to control the exhaust gas flow rate.

The material of the component constituting the exhaust part 170 is not particularly limited, and examples thereof include polysulfone, polyethersulfone, polyphenylene sulfide, polyetheretherketone, polyimide, polyetherimide, fluororesin, metals such as iron, aluminum, stainless steel, and gold, quartz, boron nitride, and the like. It is preferable to be made of boron nitride. This is because it can suppress an uneven exhaust gas flow due to rusting and the precipitation of solids caused by unintended reactions with unreacted raw materials.

When the film-forming chamber 107 includes the moving mechanism 160 as described above, the exhaust port 111 (exhaust part 170) may be moved by providing the exhaust port 111 on the moving mechanism 160.

By the way, the film-forming chamber 107 may be shaped to completely enclose the whole and have the exhaust port 111 on its wall surface, or it may enclose only part (i.e., have a gap) and further have an exhaust part (exhaust port 111) different from the gap. Especially in the latter case, a film with even better in-plane uniformity of film thickness can be formed.

Regarding the thermal reaction of the mist in the film-forming part 140, a reaction condition and the like are not particularly limited as long as the mist reacts by heating. It can be appropriately set depending on raw materials and films to be formed. For example, the heating temperature can be in the range of 120 to 600°C, preferably in the range of 200°C to 600°C, and more preferably in the range of 300°C to 550°C. When the heating temperature is T [°C], the area of the nozzle opening surface 152 is S [$cm^2$], and the flow rate of the carrier gas is Q [L/min], ST/Q is preferably 40 or more, and more preferably 100 or more and 2000 or less. When ST/Q $\geq$ 40, the film has better in-plane uniformity of film thickness.

The thermal reaction may be performed under any of vacuum, non-oxygen atmosphere, reducing gas atmosphere, air atmosphere, and oxygen atmosphere, and it can be appropriately set depending on films to be formed. A reaction pressure may be any of under atmospheric, pressurized, and depressurized conditions, but film-formation under atmospheric pressure is preferable because it can simplify an apparatus configuration.

(Carrying Part)

The carrying part 109 connects the mist part 120 to the film-forming part 140. The mist is carried by the carrier gas from the mist generator 104 of the mist part 120 to the nozzle 150 of the film-forming part 140 via the carrying part 109. The carrying part 109 can be, for example, a supply tube 109a. For example, a quartz tube, resin tube or the like can be used as the supply tube 109a.

(Raw Material Solution)

The raw material solution (aqueous solution) 104a is not particularly limited as long as it contains a material that can be atomized into a mist, and may be an inorganic material or an organic material. A solution of metal or metal compound is preferably used for the raw material solution, and a solution that contains one, or two or more metals selected from gallium, iron, indium, aluminum, vanadium, titanium, chromium, rhodium, nickel, and cobalt can be used.

The raw material solution is not particularly limited as long as the above metal solution can be atomized into a mist, but a solution obtained by dissolving or dispersing a metal in an organic solvent or water in the form of a complex or salt can be preferably used as the raw material solution. Examples of the complex form include an acetylacetonate complex, carbonyl complex, ammine complex, hydride complex, and the like. Examples of the salt form include metal chloride salt, metal bromide salt, metal iodide salt, and the like. Further, a solution obtained by dissolving the above metal in hydrobromic acid, hydrochloric acid, hydroiodic acid, or the like can also be used as an aqueous salt solution. A solute concentration is preferably 0.01 to 1 mol/L.

The raw material solution may also be mixed with an additive such as the one containing halogen (e.g., hydrohalic acid), or an oxidizing agent. Examples of the hydrohalic acid include hydrobromic acid, hydrochloric acid, hydroiodic acid, and the like, but hydrobromic acid or hydroiodic acid is preferable. Examples of the oxidizing agent include peroxide such as hydrogen peroxide ($H_2O_2$), sodium peroxide ($Na_2O_2$), barium peroxide ($BaO_2$), and benzoyl peroxide ($C_6H_5CO)_2O_2$, hypochlorous acid (HClO), perchloric acid, nitric acid, ozone water, organic peroxide such as peracetic acid and nitrobenzene, and the like.

In addition, the raw material solution may contain a dopant. The dopant is not particularly limited. Examples of the dopant include an n-type dopant such as tin, germanium, silicon, titanium, zirconium, vanadium, or niobium, or a p-type dopant such as copper, silver, tin, iridium, or rhodium. The concentration of the dopant may be, for example, about $1.0 \times 10^{-9}$ to 1.0 mol/L, and it may be a low concentration of about $1.0 \times 10^{-7}$ mol/L or less, or a high concentration of about 0.01 mol/L or more.

(Substrate)

The substrate 110 is not particularly limited as long as a film can be formed thereon and the substrate 110 can support the film. The material of the substrate 110 is not particularly limited, and any known substrate can be used. The material of the substrate may be an organic compound or an inorganic compound. Examples of the material of the substrate include, but not limited thereto, polysulfone, polyethersulfone, polyphenylene sulfide, polyether ether ketone, polyimide, polyetherimide, fluororesin, metals such as iron, aluminum, stainless steel, and gold, silicon, sapphire, quartz, glass, gallium oxide, lithium niobate, lithium tantalate, and the like. The thickness of the substrate is not particularly limited, but preferably 10 to 2000 $\mu$m, and more preferably 50 to 800 $\mu$m.

The film may be formed directly on the substrate or may be stacked on top of an intermediate layer formed on the substrate. The intermediate layer is not particularly limited, and may be mainly composed of an oxide containing any of aluminum, titanium, vanadium, chromium, iron, gallium, rhodium, indium, and iridium, for example. More specifically, examples of the oxide includes $Al_2O_3$, $Ti_2O_3$, $V_2O_3$, $Cr_2O_3$, $Fe_2O_3$, $Ga_2O_3$, $Rh_2O_3$, $In_2O_3$, and $Ir_2O_3$, and it can be a binary metal oxide represented by $(A_xB_{1-x})_2O_3$ ($0 < x < 1$) when two elements selected from the above metal elements are A and B, or a ternary metal oxide represented by $(A_xB_yC_{1-x-y})_2O_3$ ($0 < x < 1$, $0 < y < 1$) when three elements selected from the above metal elements are A, B, and C.

In the substrate, the area of a surface on which a film is formed can be 50 $cm^2$ or more, or a diameter thereof can be 4 inches (100 mm) or more, for example. This is preferable because a film with good in-plane uniformity of film thickness and with a large area can be formed. The upper limit of the area or the diameter of the substrate is not particularly limited, but the area can be 750 $cm^2$ or the diameter can be 12 inches (300 mm), for example.

(Film-Forming Method)

Next, an example of a film-forming method of the present invention will be described below with reference to FIG. 1. First, the raw material solution 104a is contained in the mist generator 104 of the mist part 120, the substrate (crystalline substrate) 110 is placed on the hot plate 108, and the hot plate 108 is activated.

Next, the flow regulating valves 103a, 103b are opened to supply the carrier gases from the carrier gas source 102a (main carrier gas) and the carrier gas source for dilution 102b (carrier gas for dilution) into the film-forming chamber 107 and fully replace the atmosphere of the film-forming chamber 107 with the carrier gases, and to regulate and control the flow rate of the main carrier gas and the flow rate of the carrier gas for dilution.

In a mist generation step, the ultrasonic transducer 106 is vibrated and the vibration is propagated through the water 105a to the raw material solution 104a, thereby atomizing the raw material solution 104a into a mist to generate the mist.

Next, in a mist carrying step of carrying the mist by the carrier gas, the mist is carried by the carrier gas from the mist part 120 to the film-forming part 140 through the carrying part 109, and is introduced into the film-forming chamber 107.

Then, in a film-forming step, the mist is supplied from the nozzle 150 provided above the placement part 112 (hot plate 108 on which the substrate 110 is placed) to between the top plate 153 provided above the placement part 112 and the substrate 110. The mist is then rectified by the provided top plate 153 and the exhaust from the exhaust part 170 (exhaust port 111 or the like) to be supplied onto the substrate 110, and heat treated and thermally reacted by the heat of the hot plate 108 in the film-forming chamber 107, and a film is formed on the substrate 110.

Such a film-forming method enables the formation of a film with better substrate in-plane uniformity of film thickness as compared to a conventional method without the top plate 153.

Forming a film while moving the substrate 110 below the nozzle 150 by the moving mechanism 160 is effective for forming a film with a large area and is effective for forming a film with more excellent in-plane uniformity of film thickness.

In the present invention, annealing process may be performed after film-formation. The temperature of the annealing process is not particularly limited, but 600°C or lower is preferable, and 550°C or lower is more preferable. This is because the crystallinity of the film is not impaired. The processing time of the annealing process is not particularly limited, but it is preferably 10 seconds to 10 hours, and more preferably 10 seconds to 1 hour.

EXAMPLES

The present invention will be described in detail below with examples, but this does not limit the present invention.

(Example 1)

In this example, the film-forming apparatus shown in FIG. 1 was used.

One top plate 153 is fixed to be in contact with the side surface of the nozzle 150 in the same plane as the nozzle opening surface 152. When the area of the top plate is B [$cm^2$], B = 450, and the difference in height position between the placement surface of the placement part 112 (top surface of the hot plate 108) and the bottom surface of the top plate 153 is I [cm], I = 0.95. The thickness of the top plate is 4 mm.

The top plate 153 is rectangular in shape (also referred to as a top plate 153i) as shown in FIG. 17, and the nozzle 150 is inserted into the hole formed in the middle.

Gallium iodide was dissolved in water to prepare an aqueous solution of 0.05 mol/L, and this was used as the raw material solution 104a. The raw material solution 104a obtained as described above was contained in the mist generator 104. The temperature of the solution at this time was 25°C.

Next, a 4 inches (100 mm diameter) c-plane sapphire substrate as the substrate 110 was placed on the hot plate 108 in the film-forming chamber 107, and the hot plate 108 was activated to raise its temperature to 500°C.

Then, the flow regulating valves 103a, 103b were opened to supply nitrogen gases as the carrier gases from the carrier gas source 102a (main carrier gas) and the carrier gas supply source for dilution 102b (carrier gas for dilution) into the film-forming chamber 107 and fully replace the atmosphere of the film-forming chamber 107 with these carrier gases, and the flow rate of the main carrier gas and the flow rate of the carrier gas for dilution were regulated to 12 L/min and 12 L/min, respectively.

Next, the exhaust flow adjustment valve 173 was adjusted such that the amount of exhaust E [L/min] at the exhaust port 111 was 24, using the exhaust part 170 as shown in FIG. 16. In this case, E/Q = 1.

Next, the ultrasonic transducer 106 was vibrated at 2.4 MHz, and the vibration was propagated through the water 105a to the raw material solution 104a, thereby atomizing the raw material solution 104a into a mist to generate the mist.

The mist was supplied to the substrate 110 through the supply tube 109a and the nozzle 150 by the carrier gas. As the nozzle 150, a nozzle with the nozzle opening surface 152 having a rectangular shape was used, and when the area of the nozzle opening surface 152 was S [$cm^2$], the flow rate of the carrier gas was Q [L/min], the difference in height position between the nozzle opening surface 152 and the substrate 110 (the longest distance between a point in the nozzle opening surface 152 and the surface of the substrate 110 ) was H [cm], it was adjusted such that SH/Q = 0.07. In this case, S = 1.92, H = 0.9, and Q = 24.

Then, a thin film of gallium oxide ($\alpha$-$Ga_2O_3$) with a corundum structure was formed on the substrate 110 by thermally reacting the mist in the film-forming chamber 107 while exhausting gas from the exhaust port 111 under atmospheric pressure and at 500°C. The film-formation time was 30 minutes.

When the heat treatment temperature was T [°C], ST/Q = 40, when the area of the substrate was A [$cm^2$], S/A = 0.024, and when the length of the long axis of the nozzle opening surface 152 was L [cm] and the maximum length of the substrate in the nozzle long axis direction was R [cm], L/R = 1.2. In this case, T = 500, A = 78.5, L = 12, and R = 10. Further, B/A = 5.7.

The substrate and the hot plate were moved back and forth by the moving mechanism 160a as shown in FIG. 13 such that they passed under the nozzle once per minute at a speed of 15 cm/min.

(Comparative Example 1)

Film-formation was performed in the same manner as Example 1 except that the top plate 153 was not used.

(Example 2)

Film-formation was performed in the same manner as Example 1 except that the area S of the nozzle opening surface 152 was changed to 6.0 $cm^2$, the difference in height position H between the nozzle opening surface 152 and the substrate 110 was changed to 2.0 cm, the difference in height position I between the bottom surface of the top plate 153 and the placement surface of the placement part 112 was changed to 2.05 cm, SH/Q = 0.5, ST/Q = 125, and S/A = 0.076.

(Example 3)

Film-formation was performed in the same manner as Example 1 except that the fixed position of the top plate was changed and the shortest distance I between the placement part 112 and the bottom surface of the top plate 153 was set to 2.05 cm.

(Example 4)

Film-formation was performed in the same manner as Example 1 except that the curved top plate 153b was used as shown in FIG. 8. In this case, the difference in height position I between the placement surface of the placement part 112 and the center of the bottom surface of the top plate 153b = 0.95, and the difference in height position between the end portion of the bottom surface of the top plate 153b and the placement surface of the placement part was 1.25 cm.

(Example 5)

Film-formation was performed in the same manner as Example 1 except that the area B of the bottom surface of the top plate 153 = 40. In this case, B/A = 0.5.

(Example 6)

Film-formation was performed in the same manner as Example 1 except that the area S of the nozzle opening surface 152 was changed to 6.0 cm², the difference in height position H between the nozzle opening surface 152 and the substrate 110 was changed to 0.1 cm, the difference in height position I between the bottom surface of the top plate 153 and the placement surface of the placement part 112 was changed to 0.15 cm, the total flow rate of the carrier gas was set to 12 L/min, SH/Q = 0.05, ST/Q = 250, and S/A = 0.076.

(Example 7)

Film-formation was performed in the same manner as Example 1 except that the area S of the nozzle opening surface 152 was changed to 6.0 cm², the difference in height position H between the nozzle opening surface 152 and the substrate 110 was changed to 6.0 cm, the difference in height position I between the bottom surface of the top plate 153 and the placement surface of the placement part 112 was changed to 6.05 cm, the total flow rate of the carrier gas was set to 72 L/min, SH/Q = 0.5, ST/Q = 41.7, and S/A = 0.076.

(Example 8)

Film-formation was performed in the same manner as Example 1 except that an aluminum acetylacetonate complex was dissolved in a hydrochloric acid solution to prepare a solution of 0.05 mol/L, and this was used as the raw material solution.

(Example 9)

Film-formation was performed in the same manner as Example 1 except that gallium nitrate was dissolved in water to prepare a solution of 0.05 mol/L, this was used as the raw material solution, E was set to 188.4 L/min, and E/Q was set to 7.9.

(Example 10)

Film-formation was performed in the same manner as Example 1 except that the shape of the nozzle opening surface 152 was circular with a diameter of 2 inches (5 cm), the substrate was not moved (the nozzle and the top plate are always positioned vertically above the substrate), the flow rate of the carrier gas was changed to a total of 80 L/min, a circular top plate 153h consisting of a 6 cm diameter circular hole and a 10 cm diameter circle as shown in FIG. 15 was used, and the nozzle was inserted into the circular hole in the top plate and there was a gap (0.5 cm) between the nozzle side surface and the top plate. In this case, SH/Q = 0.22, ST/Q = 123, S/A = 0.25, and L/R = 0.5.

(Example 11)

Film-formation was performed in the same manner as Example 1 except that the difference in height position H between the nozzle opening surface 152 and the substrate 110 was changed to 6.5 cm, the difference in height position I between the bottom surface of the top plate 153 and the placement surface of the placement part 112 was changed to 6.55 cm, and the total flow rate of the carrier gas was set to 72 L/min. In this case, SH/Q = 0.17 and ST/Q = 13.3.

(Example 12)

Film-formation was performed in the same manner as Example 1 except that the size of the hole in the center of the top plate 153 (153i) was changed and a 2 cm gap was provided between the top plate and the nozzle side surface. In this case, B = 420 and B/A = 5.4.

(Example 13)

Film-formation was performed in the same manner as Example 12 except that the exhaust port 111 was provided above the nozzle as shown in FIG. 18, E was set to 120 L/min, and E/Q was set to 5. The mist and the carrier gas were supplied from the nozzle and film-formation was performed on the substrate, and the exhaust gas was exhausted from the exhaust port 111 through the gap between the top plate and the nozzle side surface.

(Measurement of Film Thickness Distribution)

The film thickness of the thin film formed on the substrate 110 was measured using a step gauge with 50 points in the plane on the substrate 110 as measurement points. An average film thickness was calculated from each value.

The film thickness distribution calculated as (film thickness distribution [±%]) = (maximum film thickness - minimum film thickness)/(average film thickness)/2 × 100 is shown in Table 1.

Note that the same result was obtained by measuring the film thickness of the thin film formed on the substrate 110 using an optical interference type film thickness meter F50 with 25 points in the plane on the substrate 110 as measurement points.

[Table 1]

| | Raw material | Top plate shape | Distance between top plate and nozzle [cm] | B/A | I [cm] | H [cm] | E/Q | Substrate movement | Distribution [±%] |
|---|---|---|---|---|---|---|---|---|---|
| Ex. 1 | $GaI_3$ | Rectangle | 0 | 5.7 | 0.95 | 0.9 | 1 | Reciprocation | 4 . 1 |
| Comp. Ex. 1 | $GaI_3$ | - | 0 | - | - | 0.9 | 1 | Reciprocation | 21.7 |
| Ex. 2 | $GaI_3$ | Rectangle | 0 | 5.7 | 2.05 | 2.0 | 1 | Reciprocation | 3.1 |
| Ex. 3 | $GaI_3$ | Rectangle | 0 | 5.7 | 2.05 | 0.9 | 1 | Reciprocation | 6.1 |
| Ex. 4 | $GaI_3$ | Rectangle (curved) | 0 | 5 . 7 | 0.95 | 0.9 | 1 | Reciprocation | 6.5 |
| Ex. 5 | $GaI_3$ | Rectangle | 0 | 0.5 | 0.95 | 0.9 | 1 | Reciprocation | 9.0 |
| Ex. 6 | $GaI_3$ | Rectangle | 0 | 5 . 7 | 0.15 | 0.1 | 1 | Reciprocation | 7.4 |
| Ex. 7 | $GaI_3$ | Rectangle | 0 | 5 . 7 | 6.05 | 6.0 | 1 | Reciprocation | 9.8 |
| Ex. 8 | Al $(acac)_3$ | Rectangle | 0 | 5 . 7 | 0.95 | 0.9 | 1 | Reciprocation | 7.2 |
| Ex. 9 | Ga $(NO_3)_3$ | Rectangle | 0 | 5 . 7 | 0.95 | 0.9 | 7.9 | Reciprocation | 10.0 |
| Ex. 10 | $GaI_3$ | circle | 0.5 | 0.64 | 0.95 | 0.9 | 1 | N/A | 9.8 |
| Ex. 11 | $GaI_3$ | Rectangle | 0 | 5 . 7 | 6.55 | 6.5 | 1 | Reciprocation | 11.7 |
| Ex. 12 | $GaI_3$ | Rectangle | 2 | 5.4 | 0.95 | 0.9 | 1 | Reciprocation | 6.3 |
| Ex. 13 | $GaI_3$ | Rectangle | 2 | 5.4 | 0.95 | 0.9 | 5 | Reciprocation | 8.2 |

From the comparison of Examples 1 to 13 and Comparative Example 1, it was found that the use of the film-forming apparatus including the mist part, the carrier gas supplier, the film-forming part, and the exhaust part, and including the nozzle that supplies the mist onto the substrate and the top plate that rectifies the mist, which are provided above the placement part on which the substrate is placed inside the film-forming part, resulted in a film with excellent in-plane uniformity of film thickness.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

**Claims**

1. A film-forming apparatus that heat-treats a raw material solution atomized into a mist to perform film-formation on a substrate, the film-forming apparatus comprising:

   a mist part that generates a mist by atomizing the raw material solution into a mist;
   a carrier gas supplier that supplies a carrier gas to carry the mist generated in the mist part;
   a film-forming part inside which a placement part on which the substrate is placed is provided, and in which the mist carried by the carrier gas is suppled onto the substrate; and

an exhaust part that exhausts an exhaust gas from the film-forming part,
the film-forming apparatus further comprising:

above the placement part inside the film-forming part,
a nozzle that supplies the mist onto the substrate; and
a top plate that rectifies the mist supplied from the nozzle.

2. The film-forming apparatus according to claim 1, wherein the nozzle and the top plate are provided vertically above the placement part.

3. The film-forming apparatus according to claim 1 or 2, wherein the top plate is provided in contact with a side surface of the nozzle.

4. The film-forming apparatus according to any one of claims 1 to 3, wherein the top plate is provided in the same plane as an opening surface of the nozzle.

5. The film-forming apparatus according to any one of the claims 1 to 4, wherein the top plate is provided such that a bottom surface of the top plate is parallel to a surface on which the substrate is placed of the placement part.

6. The film-forming apparatus according to any one of the claims 1 to 5, wherein the top plate is provided such that a difference in height position between a bottom surface of the top plate and a surface on which the substrate is placed of the placement part is 0.15 cm or more and 6.05 cm or less.

7. The film-forming apparatus according to any one of the claims 1 to 6, wherein the nozzle is provided such that a difference in height position between an opening surface of the nozzle and the substrate placed on the placement part is 0.1 cm or more and 6.0 cm or less.

8. The film-forming apparatus according to any one of claims 1 to 7, wherein when an area of a bottom surface of the top plate is B [cm$^2$], B $\geq$ 40.

9. The film-forming apparatus according to any one of claims 1 to 8, wherein when an area of the substrate is A [cm$^2$] and an area of a bottom surface of the top plate is B [cm$^2$], B/A $\geq$ 0.5.

10. The film-forming apparatus according to any one of claims 1 to 9, further comprising a moving mechanism that moves the substrate below the nozzle.

11. The film-forming apparatus according to any one of claims 1 to 10, wherein the raw material solution contains gallium.

12. The film-forming apparatus according to any one of claims 1 to 11, wherein the raw material solution contains halogen.

13. A film-forming method that heat-treats a raw material solution atomized into a mist to perform film-formation on a substrate, the method comprising:

a mist generation step of generating a mist by atomizing the raw material solution into a mist;
a mist carrying step of carrying the mist to a film-forming part by a carrier gas; and
a film-forming step of supplying the mist onto the substrate placed on a placement part inside the film-forming part and heat-treating the mist to perform film-formation while exhausting an exhaust gas, wherein
in the film-forming step,
when supplying the mist onto the substrate, by supplying the mist from a nozzle provided above the placement part to between a top plate provided above the placement part and the substrate, the mist rectified is supplied onto the substrate.

14. The film-forming method according to claim 13, wherein the nozzle and the top plate are provided vertically above the placement part.

15. The film-forming method according to claim 13 or 14, wherein the top plate is provided in contact with a side surface of the nozzle.

16. The film-forming method according to any one of claims 13 to 15, wherein the top plate is provided in the same plane as an opening surface of the nozzle.

17. The film-forming method according to any one of claims 13 to 16, wherein the top plate is provided such that a bottom surface of the top plate is parallel to a surface on which the substrate is placed of the placement part.

18. The film-forming method according to any one of claims 13 to 17, wherein the top plate is provided such that a difference in height position between a bottom surface of the top plate and a surface on which the substrate is placed of the placement part is 0.15 cm or more and 6.05 cm or less.

19. The film-forming method according to any one of claims 13 to 18, wherein the nozzle is provided such that a difference in height position between an opening surface of the nozzle and the substrate placed on the placement part is 0.1 cm or more and 6.0 cm or less.

20. The film-forming method according to any one of claims 13 to 19, wherein when an area of a bottom surface of the top plate is B [$cm^2$], $B \geq 40$.

21. The film-forming method according to any one of claims 13 to 20, wherein when an area of the substrate is A [$cm^2$] and an area of a bottom surface of the top plate is B [$cm^2$], $B/A \geq 0.5$.

22. The film-forming method according to any one of claims 13 to 21, wherein in the film-forming step, the substrate is moved below the nozzle.

23. The film-forming method according to any one of claims 13 to 22, wherein the raw material solution contains gallium.

24. The film-forming method according to any one of claims 13 to 23, wherein the raw material solution contains halogen.

25. The film-forming method according to any one of claims 13 to 24, wherein when a flow rate of the carrier gas supplied from the nozzle is Q [L/min] and a flow rate of the exhaust gas is E [L/min], E/Q is 5 or less.

26. The film-forming method according to any one of claims 13 to 25, wherein in the substrate, a surface on which a film is formed has an area of 50 $cm^2$ or more, or has a diameter of 4 inches (100 mm) or more.

27. A gallium oxide film with a corundum structure, wherein

    the gallium oxide film has an area of 50 $cm^2$ or more, or has a diameter of 4 inches (100 mm) or more, and
    an in-plane distribution of a film thickness of the gallium oxide film is $\pm 3.1\%$ or more and $\pm 11.7\%$ or less.

28. A laminate of a substrate and a gallium oxide film with a corundum structure, wherein

    the gallium oxide film of the laminate has an area of 50 $cm^2$ or more, or has a diameter of 4 inches (100 mm) or more, and
    an in-plane distribution of a film thickness of the gallium oxide film is $\pm 3.1\%$ or more and $\pm 11.7\%$ or less.

[FIG. 1]

[FIG. 2]

120

[FIG. 3]

[FIG. 4]

[FIG. 5]

[FIG. 6]

[FIG. 7]

[FIG. 8]

[FIG. 9]

[FIG. 10]

[FIG. 11]

[FIG. 12]

[FIG. 13]

160a

110    108    161a    150    153f

[FIG. 14]

108

161b    110    160b

150

150

153g

108
110

[FIG. 15]

153h

[FIG. 16]

[FIG. 17]

<u>153i</u>

[FIG. 18]

[FIG. 19]

## INTERNATIONAL SEARCH REPORT

| International application No. |
|---|
| **PCT/JP2022/010549** |

**A. CLASSIFICATION OF SUBJECT MATTER**

*C30B 25/14*(2006.01)i; *H01L 21/365*(2006.01)i; *H01L 21/368*(2006.01)i; *C23C 16/455*(2006.01)i
FI: C23C16/455; C30B25/14; H01L21/365; H01L21/368 Z

According to International Patent Classification (IPC) or to both national classification and IPC

**B. FIELDS SEARCHED**

Minimum documentation searched (classification system followed by classification symbols)

C23C16/455; C30B25/14; H01L21/365; H01L21/368

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2019-7048 A (TOYOTA MOTOR CORP) 17 January 2019 (2019-01-17) paragraphs [0013]-[0034] | 1, 2, 5, 9, 11, 13, 14, 17, 21, 23 |
| Y | | 6, 7, 8, 10, 12, 18, 19, 20, 22, 24-26 |
| Y | JP 2017-20076 A (TOSHIBA MITSUBISHI-ELECTRIC IND SYSTEM CORP) 26 January 2017 (2017-01-26) paragraphs [0011]-[0062] | 6, 7, 18, 19 |
| X | JP 2020-2396 A (SHINETSU CHEMICAL CO) 09 January 2020 (2020-01-09) paragraphs [0026]-[0064] | 27, 28 |
| Y | | 8, 12, 20, 24, 25, 26 |
| A | | 3, 4, 15, 16 |
| Y | JP 2015-96629 A (SHIKOKU INSTRUMENTATION CO LTD) 21 May 2015 (2015-05-21) paragraphs [0013]-[0055] | 10, 22 |

☐ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **11 May 2022** | **24 May 2022** |

| Name and mailing address of the ISA/JP | Authorized officer |
|---|---|
| **Japan Patent Office (ISA/JP)** 3-4-3 Kasumigaseki, Chiyoda-ku, Tokyo 100-8915 Japan | |
| | Telephone No. |

Form PCT/ISA/210 (second sheet) (January 2015)

**INTERNATIONAL SEARCH REPORT**
**Information on patent family members**

International application No.

**PCT/JP2022/010549**

| Patent document cited in search report | | | Publication date (day/month/year) | Patent family member(s) | Publication date (day/month/year) |
|---|---|---|---|---|---|
| JP | 2019-7048 | A | 17 January 2019 | US 2018/0371613 A1 paragraphs [0013]-[0042] CN 109107797 A | |
| JP | 2017-20076 | A | 26 January 2017 | (Family: none) | |
| JP | 2020-2396 | A | 09 January 2020 | (Family: none) | |
| JP | 2015-96629 | A | 21 May 2015 | (Family: none) | |

Form PCT/ISA/210 (patent family annex) (January 2015)

**EP 4 306 686 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H01257337 A
- JP 2005307238 A
- JP 2012046772 A
- JP 5397794 B
- JP 2014063973 A